# EUROPÄISCHE PATENTSCHRIFT

(11) **EP 2 409 166 B1**
(45) Veröffentlichungstag und Bekanntmachung des Hinweises auf die Patenterteilung: **28.11.2012**
(21) Anmeldenummer: 10707465.0
(22) Anmeldetag: 01.03.2010
(51) Int. Cl.: G01R 1/067

(54) **Hochfrequenz-Messpitze**
High frequency measuring probe
Pointe de mesure haute frequence

(30) Priorität: 20.03.2009 DE 202009003966 U
(43) Veröffentlichungstag der Anmeldung: 25.01.2012
(73) Patentinhaber: Rosenberger Hochfrequenztechnik GmbH & Co. KG, 83413 Fridolfing (DE)
(72) Erfinder: THIES, Steffen, A-5122 Überackern (AT)
(74) Vertreter: Zeitler - Volpert - Kandlbinder
(86) Internationale Anmeldenummer: PCT/EP2010/001251
(87) Internationale Veröffentlichungsnummer: WO 2010/105736

(56) Entgegenhaltungen:
- DE-A1- 19 945 178
- US-A- 5 565 788

## Beschreibung

Die vorliegende Erfindung betrifft eine Messspitze zur Hochfrequenzmessung mit einem kontaktseitigen Ende zum elektrischen Kontaktieren von planaren Strukturen und einem kabelseitigen Ende, insbesondere einem koaxialkabelseitigen Ende, zum Verbinden mit einem Kabel, insbesondere einem Koaxialkabel, wobei zwischen dem kontaktseitigen Ende und dem kabelseitigen Ende eine koplanare Leiterstruktur mit wenigstens zwei Leitern, insbesondere drei Leitern, angeordnet ist, wobei auf der koplanaren Leiterstruktur über einen vorbestimmten Abschnitt zwischen dem kabelseitigen Ende und dem kontaktseitigen Ende einseitig oder beidseitig, ein die koplanare Leiterstruktur halterndes Dielektrikum angeordnet ist, wobei zwischen dem Dielektrikum und dem kontaktseitigen Ende die Messspitze derart ausgebildet ist, dass die Leiter der koplanaren Leiterstruktur frei im Raum und bzgl. des hafternden Dielektrikums federnd angeordnet sind, gemäß dem Oberbegriff des Anspruchs 1.

Eine derartige Messspitze ist beispielsweise aus der DE 199 45 178 A1 bekannt. Diese hat den Vorteil, dass eine kostengünstige und präzise auch in Serienfertigung herstellbare Messspitze mit Impedanzkontrolle zur Verfügung steht, so dass sich geringe Reflektionen bei der Kontaktierung mit der planaren Struktur zu Messzwecken ergeben. Die erfindungsgemäße Anordnung zeichnet sich durch Betriebsfrequenzen von bis zu 40 bis 60 GHz oder mehr aus, wobei die Impedanz über die gesamte koplanare Leiterstruktur aufgrund der erfindungsgemäßen Ausbildung im wesentlichen dispersionsfrei, d.h. unabhängig von der Betriebsfrequenz, ist. Durch die frei federnde Anordnung der Leiter der koplanaren Leiterstruktur zwischen dem Dielektrikum und dem koaxialkabelseitigen Ende ist eine hohe Kontaktqualität zwischen allen Leitern der koplanaren Leiterstruktur und entsprechenden Kontaktstellen einer zu prüfenden Einrichtung gewährleistet, wobei die Kontaktqualität unempfindlich bzgl. eines verkippten aufsetzens der Messspitze auf die Kontaktstellen der planaren Struktur ist.

Aus der US 5 565 788 ist eine abgeschirmte Mikrowellenmessspitze bekannt, mit einem Ende eines Koaxialkabels, welches mit Messfingern verbunden ist, die eine koplanare Leitung mit Massefingern und einem Signalfinger ausbilden. Die Massefinger sind über ein Abschirmelement miteinander verbunden. Das Abschirmelement ist von dem Signalfinger beabstandet und zwischen diesem sowie einem Prüfling angeordnet, um Störsignale und parasitäre Einkopplungen von dem Prüfling, die die Messgenauigkeit beeinträchtigen würden, zu verhindern.

Der Erfindung liegt die Aufgabe zugrunde, eine Messspitze der o.g. Art hinsichtlich deren elektrischer Eigenschaften weiter zu verbessern

Diese Aufgabe wird erfindungsgemäß durch eine Messspitze der o.g. Art mit den in Anspruch 1 gekennzeichneten Merkmalen gelöst. Vorteilhafte Ausgestaltungen der Erfindung sind in den weiteren Ansprüchen beschrieben.

Bei einer Messspitze der o.g. Art ist es erfindungsgemäß vorgesehen, dass an einer Seite der Messspitze, welche bei kontaktieren der planaren Struktur dieser zugewandt ist, ein Abschirmelement derart angeordnet und ausgebildet ist, dass sich das Abschirmelement bis in den Bereich der frei im Raum und bzgl. des halternden Dielektrikums federnd angeordneten koplanaren Leiterstruktur zwischen dem Dielektrikum und dem kontaktseitigen Ende erstreckt, wobei die Messspitze ein Gehäuse aus einem elektrisch leitenden Werkstoff aufweist, wobei das Abschirmelement mit dem Gehäuse elektrisch verbunden ist.

Dies hat den Vorteil, dass die frei im Raum und bzgl. des halternden Dielektrikums federnd angeordnete, koplanare Leiterstruktur von der planaren Struktur elektrisch abgeschirmt ist, so dass ein unerwünschtes Übersprechen von elektrischen Signalen aus der planaren Leiterstruktur in den frei federnden Teil der koplanaren Leiterstruktur wirksam verhindert ist und gleichzeitig unerwünschte elektrische Effekte, insbesondere hinsichtlich der Kalibrierung, aufgrund der Nähe zwischen koplanarer Leiterstruktur und planarer Struktur vermieden oder zumindest deutlich reduziert sind.

Eine besonders gute elektrische Abschirmung bei gleichzeitig geringer Dicke des Abschirmelementes der koplanaren Leiterstruktur von der planaren Struktur erzielt man dadurch, dass das Abschirmelement aus einem elektrisch leitenden Werkstoff hergestellt ist.

In einer bevorzugten Ausführungsform ist das Abschirmelement mit wenigstens einem Leiter der frei im Raum und bzgl. des halternden Dielektrikums federnd angeordneten koplanaren Leiterstruktur elektrisch verbunden.

Zweckmäßigerweise ist das Abschirmelement an einem dem kontaktseitigen Ende der Messspitze zugewandten Ende mit wenigstens einem Leiter der frei im Raum und bzgl. des halternden Dielektrikums federnd angeordneten koplanaren Leiterstruktur elektrisch verbunden.

Eine besonders einfache Herstellung eines elektrischen Kontaktes zwischen Abschirmelemente und einem Leiter der koplanaren Leiterstruktur erzielt man dadurch, dass das Abschirmelement mit dem wenigstens einem Leiter der frei im Raum und bzgl. des halternden Dielektrikums federnd angeordneten koplanaren Leiterstruktur zusätzlich mechanisch verbunden ist.

In einer bevorzugten Ausführungsform ist die Leitung der koplanaren Leiterstruktur, mit der das Abschirmelement elektrisch bzw. mechanisch verbunden ist, ein Masseleiter.

In einer bevorzugten Ausführungsform weist die koplanare Leiterstruktur drei Leiter auf, wobei ein mittiger Leiter ein Signalleiter und zwei Leiter Masseleiter sind.

Zu weiteren Verbesserung der Abschirmung ist an einer der Seite der Messspitze gegenüberliegenden Seite ein zusätzliches Abschirmelement derart angeordnet und ausgebildet, dass sich das zusätzliche Abschirmelement bis in den Bereich der frei im Raum und bzgl. des halternden Dielektrikums federnd angeordneten koplanaren Leiterstruktur zwischen dem Dielektrikum und dem kontaktseitigen Ende erstreckt.

Die Erfindung wird im Folgenden anhand der Zeichnung näher erläutert. Diese zeigt in:
- Fig. 1: eine bevorzugte Ausführungsform einer erfindungsgemäßen Messspitze in einer Ansicht von unten auf eine einer planaren Leiterstruktur zugewandte Seite,
- Fig. 2: die Messspitze gemäß Fig. 1 in Seitenansicht,
- Fig. 3: eine vergrößerte Detailansicht des Bereiches A von Fig. 2 und
- Fig. 4: die Messspitze gemäß Fig. 1 in Vorderansicht auf ein kontaktseitiges Ende der Messspitze in Richtung von Pfeil B von Fig. 3.

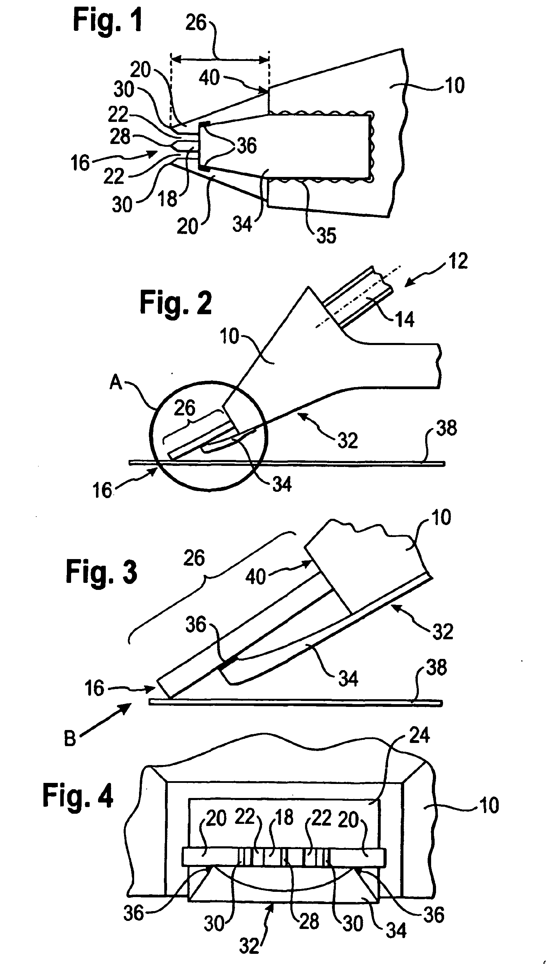

Die in den Fig. 1 bis 4 dargestellte, bevorzugte Ausführungsform einer erfindungsgemäßen Messspitze umfasst ein Gehäuse 10, ein koaxialkabelseitiges Ende 12 mit einem Koaxialsteckverbinder 14 zum Verbinden mit einem Koaxialkabel (nicht dargestellt), ein kontaktseitiges Ende 16 zum kontaktieren einer planaren Struktur 38, eine zwischen dem koaxialkabelseitiges Ende 12 und dem kontaktseitigen Ende 16 ausgebildete koplanare Leiterstruktur mit einem mittigen Signalleiter 18 und zwei Masseleitern 20. Zwischen dem Signalleiter 18 und den benachbarten Masseleitern 20 der koplanaren Leiterstruktur ist ein jeweiliger Spalt 22 ausgebildet. Dieser Spalt 22 ist über die gesamte Länge der koplanaren Leiterstruktur 18, 20 derart ausgebildet, dass sich ein konstanter, vorbestimmter Wellenwiderstand ergibt.

In einem mittleren Abschnitt zwischen dem koaxialkabelseitigen Ende 12 und dem kontaktseitigen Ende 16 ist die koplanare Leiterstruktur 18, 20 von einem Dielektrikum 24 (Fig. 4), beispielsweise in Form eines Quarzblockes gehalten, wobei das Dielektrikum 24 einseitig oder beidseitig der koplanaren Leiterstruktur 18, 20 angeordnet ist, so dass die koplanaren Leiterstruktur 18, 20 beidseitig von jeweils einem Dielektrikum 24 gehalten ist. Hierbei sind das Dielektrikum 24 und die koplanare Leiterstruktur 18, 20 in einer sandwichartigen Struktur aufeinander gelegt. Das Dielektrikum 24 ist mit der koplanaren Leiterstruktur 18, 20 fest verbunden und trägt jeweils an einer der koplanaren Leiterstruktur 18, 20 zugewandten Seite eine Metallisierung, welche im Wesentlichen der Form der koplanaren Leiterstruktur 18, 20 im Bereich des Dielektrikums 24 entspricht. Auf diese Weise erzielt man eine besonders gut haltende und enge Verbindung zwischen dem Dielektrikum 24 und den Leitern 18, 20 der koplanaren Leiterstruktur. Aufgrund der elektromagnetischen Verhältnisse mit dem Dielektrikum 24 ist der Spalt 22 im Bereich des Dielektrikums 24 verbreitert, so dass sich insgesamt ein konstanter Wellenwiderstand über die gesamte Länge der koplanaren Leiterstruktur 18, 20 vom koaxialkabelseitigen Ende 12 bis zum kontaktseitigen Ende 16 ergibt. Das Dielektrikum 24 ist in das Gehäuse 10 derart eingebettet, dass das Dielektrikum 24 an einer dem kontaktseitigen Ende 16 zugewandten Ende 40 des Gehäuses mit diesem bündig abschließt.

Die Leiter 18, 20 sind in einem Bereich 26 zwischen dem Dielektrikum 24 und dem kontaktseitigen Ende 16 frei im Raum angeordnet, so dass jeder Leiter 18, 20 individuell bezüglich der Halterung in dem Dielektrikum 24 federn kann. Wird nun das kontaktseitige Ende 16 der Messspitze mechanisch auf entsprechende Kontaktstellen der planaren Struktur 38, beispielsweise einer zu testende elektrische Schaltung, aufgedrückt, so bedingt die Möglichkeit des freien Federns für jeden einzelnen Leiter 18, 20 der koplanaren Leiterstruktur, dass jeder einzelne Leiter 18, 20 einen optimalen elektrischen Kontakt zu der ihm jeweils zugeordneten Kontaktstelle hat. Ein etwaiges Verkippen der Messspitze beim mechanischen Andrücken auf die Kontaktstellen und etwaige Toleranzen sowohl bei den Leitern 18, 20 selbst als auch an den Oberflächen der Kontaktstellen der planaren Struktur 38 werden durch das Federn der einzelnen Leiter 18, 20 ausgeglichen. Hierdurch wird bei jedem mechanischen Aufsetzen der Leiter 18, 20 auf entsprechende Kontaktstellen ein immer gleicher und definierter Kontakt hergestellt, so dass optimale Messergebnisse mit der erfindungsgemäßen Messspitze erzielbar sind.

Die Darstellung der Messspitze mit drei Leitern 18, 20 in der Anordnung Masse-Signal-Masse bzw. g-s-g (g = ground; s = signal) ist lediglich beispielhaft. Selbstverständlich sind auch koplanare Leiterstrukturen mit nur zwei Leitern 18, 20 oder mehr als drei Leitern 18, 20 möglich, mit der Aufteilung von Signalleitern und Masse- bzw. Groundleitern in folgender Weise: g-s-g-s-g-s-g... oder g-s-g-g-s-g-g-s-g-g... oder ähnliches. Auf diese Weise sind auch zu testende elektrische Schaltungen mit einer einzigen Messspitze kontaktierbar, welche mehrere koplanare Signalleitungen mit jeweiligen Kontaktstellen auf der planaren Struktur aufweisen.

Optional weist das Dielektrikum 24 an einer der koplanaren Leiterstruktur 18, 20 abgewandten Seite eine vollflächige Metallisierung (nicht dargestellt) auf. Diese Metallisierung führt einmal zum Unterdrücken von unerwünschten Moden höherer Ordnung abseits der gewünschten Betriebsfrequenz und schafft gleichzeitig über einen vorbestimmten Bereich der koplanaren Leiterstruktur 18, 20 ein geschlossenes System.

Am kontaktseitigen Ende 16 verjüngen sich die Leiter 18, 20 der koplanaren Leiterstruktur zu einer Spitze 28 des Signalleiters 18 und zu Spitzen 30 der Masseleiter 20 zum Ausbilden einer Anordnung der Leiter 18, 20, welche einer Anordnung von zu kontaktierenden Kontaktstellen der planaren Struktur 38, insbesondere einer zu testenden elektrischen Schaltung, entspricht.

Eine besonders herausragende Eigenschaft der erfindungsgemäßen Messspitze gemäß der Fig. 1 bis 4 liegt darin, dass die mittels der Spalte 22 eingestellte Impedanz über die koplanare Leiterstruktur 18, 20 hinweg im Wesentlichen dispersionsfrei ist, d.h. die Impedanz und die Phasengeschwindigkeit sind im Wesentlichen nicht abhängig von der Betriebsfrequenz.

Erfindungsgemäß ist an einer Seite 32 der Messspitze, welche bei kontaktieren der Messspitze von Kontaktstellen auf der planaren Struktur 38 dieser zugewandt ist (vgl. Fig. 2 und 3), zusätzlich ein Abschirmelement 34 angeordnet. Fig. 1 zeigt eine Ansicht auf eben diese Seite 32 der Messspitze. Dieses Abschirmelement 34 erstreckt sich zwischen dem koaxialkabelseitigen Ende 12 und dem kontaktseitigen Ende 16 bis in den Bereich 26, in dem die Leiter 18, 20 frei im Raum federn können. Bei kontaktieren der Messspitze von Kontaktstellen auf der planaren Struktur 38 ist dieses Abschirmelemente 34 somit örtlich zwischen der planaren Struktur 38 und der koplanaren Leiterstruktur 18, 20 angeordnet, wie aus Fig. 2 und 3 ersichtlich, und schirmt dementsprechend die koplanare Leiterstruktur 18, 20 von der planaren Struktur 38 bzw. der zu testenden Schaltung elektrisch bzw. elektromagnetisch ab. Unerwünschte Einflüsse der planaren Struktur 38 auf die Messspritze bzw. die koplanare Leiterstruktur 18, 20 sind dadurch wirksam vermieden bzw. mindestens deutlich reduziert. Diese unerwünschten Einflüsse betreffen beispielsweise das Einkoppeln bzw. Übersprechen von elektrischen Signalen ausgehend von der planaren Struktur 38 in die koplanare Leiterstruktur 18, 20 bzw. Veränderungen der elektrischen Eigenschaften der koplanaren Leiterstruktur 18, 20 beispielsweise hinsichtlich der Kalibrierung. All dies führt zu unerwünschten Veränderungen von Messergebnissen beim Testen der planaren Struktur 38 mit der Messspitze.

Das Abschirmelement 34 ist mit dem Gehäuse 10 elektrisch leitend verbunden, wie bei 35 in Fig. 1 angedeutet ist. Das Gehäuse 10 ist dabei bevorzugt aus einem elektrisch leitenden Werkstoff hergestellt und mittels einer entsprechenden elektrischen Verschaltung mit einem Massenkontakt elektrisch verbunden, so dass das Gehäuse 10 und damit auch das Abschirmelement 34 ein definiertes Masseniveau ausbilden. Auch das Abschirmelement 34 ist zweckmäßigerweise aus einem elektrisch leitenden Werkstoff hergestellt, so dass bereits mit geringer Dicke des Abschirmelementes 34 eine Abschirmung erzielt wird.

Zur weiteren Verbesserung der Abschirmfunktion des Abschirmelementes 34 ist dieses an einem dem kontaktseitigen Ende 16 der Messspitze zugewandten Ende elektrisch über Kontaktstellen 36 mit den beiden Masseleitern 20 verbunden. Durch eine entsprechend bewegliche bzw. flexible Ausbildung des Abschirmelementes 34 ist dabei die Beweglichkeit der Messeleiter 20 im Bereich 26 nur unwesentlich beeinträchtigt.

## Patentansprüche

1. Messspitze zur Hochfrequenzmessung mit einem kontaktseitigen Ende (16) zum elektrischen Kontaktieren von planaren Strukturen (38) und einem kabelseitigen Ende (12), insbesondere einem koaxialkabelseitigen Ende, zum Verbinden mit einem Kabel, insbesondere einem Koaxialkabel, wobei zwischen dem kontaktseitigen Ende (16) und dem kabelseitigen Ende (12) eine koplanare Leiterstruktur mit wenigstens zwei Leitern (18, 20), insbesondere drei Leitern, angeordnet ist, wobei auf der koplanaren Leiterstruktur (18, 20) über einen vorbestimmten Abschnitt zwischen dem kabelseitigen Ende (12) und dem kontaktseitigen Ende (16) einseitig oder beidseitig, ein die koplanare Leiterstruktur (18, 20) halterndes Dielektrikum (24) angeordnet ist, wobei zwischen dem Dielektrikum (24) und dem kontaktseitigen Ende (16) die Messspitze derart ausgebildet ist, dass die Leiter (18, 20) der koplanaren Leiterstruktur frei im Raum und bzgl. des halternden Dielektrikums (24) federnd angeordnet sind,
**dadurch gekennzeichnet,**
**dass** an einer Seite (32) der Messspitze, welche bei kontaktieren der planaren Struktur (38) dieser zugewandt ist, ein Abschirmelement (34) derart angeordnet und ausgebildet ist, dass sich das Abschirmelement (34) bis in den Bereich (26) der frei im Raum und bzgl. des halternden Dielektrikums (24) federnd angeordneten koplanaren Leiterstruktur (18, 20) zwischen dem Dielektrikum (24) und dem kontaktseitigen Ende (16) erstreckt, wobei die Messspitze ein Gehäuse (10) aus einem elektrisch leitenden Werkstoff aufweist, wobei das Abschirmelement (34) mit dem Gehäuse (10) elektrisch verbunden ist.

2. Messspitze nach Anspruch 1, **dadurch gekennzeichnet, dass** das Abschirmelement (34) aus einem elektrisch leitenden Werkstoff hergestellt ist.

3. Messspitze nach Anspruch 1 oder 2, **dadurch gekennzeichnet, dass** das Abschirmelement (34) mit wenigstens einem Leiter (20) der frei im Raum und bzgl. des halternden Dielektrikums federnd angeordneten koplanaren Leiterstruktur elektrisch verbunden ist.

4. Messspitze nach Anspruch 3, **dadurch gekennzeichnet, dass** das Abschirmelement (34) an einem dem kontaktseitigen Ende (16) der Messspitze zugewandten Ende mit wenigstens einem Leiter (20) der frei im Raum und bzgl. des halternden Dielektrikums federnd angeordneten koplanaren Leiterstruktur elektrisch verbunden ist.

5. Messspitze nach Anspruch 3 oder 4, **dadurch gekennzeichnet, dass** das Abschirmelement (34) mit dem wenigstens einem Leiter (20) der frei im Raum und bzgl. des halternden Dielektrikums federnd angeordneten koplanaren Leiterstruktur zusätzlich mechanisch verbunden ist.

6. Messspitze nach wenigstens einem der Ansprüche 3 bis 5, **dadurch gekennzeichnet, dass** die Leitung der koplanaren Leiterstruktur, mit der das Abschirmelement (34) elektrisch bzw. mechanisch verbunden ist, ein Masseleiter (20) ist.

7. Messspitze nach wenigstens einem der vorhergehenden Ansprüche, **dadurch gekennzeichnet, dass** die koplanare Leiterstruktur drei Leiter (18, 20) aufweist, wobei ein mittiger Leiter (18) ein Signalleiter und die übrigen zwei Leiter (20) Masseleiter sind.

8. Messspitze nach wenigstens einem der vorhergehenden Ansprüche, **dadurch gekennzeichnet, dass** an einer der Seite (32) der Messspitze gegenüberliegenden Seite ein zusätzliches Abschirmelement derart angeordnet und ausgebildet ist, dass sich das zusätzliche Abschirmelement bis in den Bereich (26) der frei im Raum und bzgl. des halternden Dielektrikums (24) federnd angeordneten koplanaren Leiterstruktur (18, 20) zwischen dem Dielektrikum (24) und dem kontaktseitigen Ende (16) erstreckt.

## Claims

1. Test prod for high-frequency measurement having a contact-side end (16) for electricity contacting planar structures (38) and a cable-side end (12), in particular a coaxial cable-side end, for connecting to a cable, in particular a coaxial cable, wherein between the contact-side end (16) and the cable-side end (12) a coplanar conductor structure having at least two conductors (18, 20), in particular three conductors, is arranged, wherein on the coplanar conductor structure (18, 20) a dielectric (24) supporting the coplanar conductor structure (18, 20) is arranged over a predetermined section between the cable-side end (12) and the contact-side end (16), one-sided or both-sided, wherein the test prod is designed between the dielectric (24) and the contact-side end (16) such that the conductors (18, 20) of the coplanar conductor structure are arranged freely in space and relative to the supporting dielectric (24) in a suspending manner, **characterised in that** on one side (32) of the test prod facing towards the planar structure (38) upon contacting said planar structure, a shielding element (34) is arranged and designed such that the shielding element (34) extends into the area (26) of the coplanar conductor structure (18, 20) which is arranged freely in space and relative to the supporting dielectric (24) in a suspending manner between the dielectric (24) and the contact-side end (16), wherein the test prod possesses a housing (10) made of an electrically conductive material, wherein the shielding element (34) is electrically connected with the housing (10).

2. Test prod according to claim 1, **characterised in that** the shielding element (34) is manufactured of an electrically conductive material.

3. Test prod according to claim 1 or 2, **characterised in that** the shielding element (34) is electrically connected with at least one conductor (20) of the coplanar conductor structure which is arranged suspended freely in space and resiliently in relation to the supporting dielectric.

4. Test prod according to claim 3, **characterised in that** the shielding element (34) is, at an end facing the contact-side end (16) of the test prod, electrically connected with at least one conductor (20) of the coplanar conductor structure which is arranged suspended freely in space and resiliently in relation to the supporting dielectric.

5. Test prod according to claim 3 or 4, **characterised in that** the shielding element (34) is, in addition, mechanically connected with the at least one conductor (20) of the coplanar conductor structure which is arranged suspended freely in space and resiliently in relation to the supporting dielectric.

6. Test prod according to at least one of the claims 3 to 5, **characterised in that** the conductor of the coplanar conductor structure with which the shielding element (34) is electrically or mechanically connected is a ground conductor (20).

7. Test prod according to at least one of the preceding claims, **characterised in that** the coplanar conductor structure possesses three conductors (18, 20), wherein a central conductor (18) is a signal conductor and the other two conductors (20) are ground conductors.

8. Test prod according to at least one of the preceding claims, **characterised in that** an additional shielding element is arranged and designed on a side (32) opposite the side of the test prod such that the additional shielding element extends into the area (26) of the coplanar conductor structure (18, 20) which is suspended freely in space and resiliently in relation to the supporting dielectric (24), between the dielectric (24) and the contact-side end (16).

## Revendications

1. Pointe de mesure pour la mesure à haute fréquence, comprenant une extrémité côté contact (16) destinée à venir en contact électrique avec des structures planaires (38) et une extrémité côté câble (12), en particulier une extrémité côté câble coaxial, à relier avec un câble, en particulier un câble coaxial, dans laquelle une structure conductrice coplanaire avec au moins deux conducteurs (18, 20), et en particulier trois conducteurs, est agencée entre l'extrémité côté contact (16) et l'extrémité côté câble (12), et un diélectrique (24) qui retient la structure conductrice coplanaire (18, 20) est agencé, sur un côté ou sur les deux côtés, sur la structure conductrice coplanaire (18, 20) sur un tronçon prédéterminé entre l'extrémité côté câble (12) et l'extrémité côté contact (16) et, entre le diélectrique (24) et l'extrémité côté contact (16), la pointe de mesure est réalisée de telle façon que les conducteurs (18, 20) de la structure conductrice coplanaire sont agencés librement dans l'espace et avec effet ressort par rapport au diélectrique (24) qui les maintient,
**caractérisée en ce que**
sur un côté (32) de la pointe de mesure qui, lors de la venue en contact de la structure planaire (38), est tourné vers celle-ci, est prévu un élément de blindage (34) qui est agencé et réalisé de telle façon que l'élément de blindage (34) s'étend jusque dans la région (26) de la structure conductrice (18, 20) coplanaire agencée librement dans l'espace et avec effet ressort par rapport au diélectrique (24) qui la maintient, entre le diélectrique (24) et l'extrémité côté contact (16), et la pointe de mesure comprend un boîtier (10) en un matériau conducteur de l'électricité, l'élément de blindage (34) étant relié électriquement avec le boîtier (10).

2. Pointe de mesure selon la revendication 1, **caractérisée en ce que** l'élément de blindage (34) est produit à partir d'un matériau conducteur de l'électricité.

3. Pointe de mesure selon la revendication 1 ou 2, **caractérisée en ce que** l'élément de blindage (34) est relié électriquement avec au moins un conducteur (20) de la structure conductrice coplanaire agencée librement dans l'espace et avec effet ressort par rapport au diélectrique qui la maintient.

4. Pointe de mesure selon la revendication 3, **caractérisée en ce que** l'élément de blindage (34) est relié, à une extrémité tournée vers l'extrémité côté contact (16) de la pointe de mesure, électriquement à au moins un conducteur (20) de la structure conductrice coplanaire agencée librement dans l'espace et avec effet ressort par rapport au diélectrique qui la maintient.

5. Pointe de mesure selon la revendication 3 ou 4, **caractérisée en ce que** l'élément de blindage (34) est relié additionnellement mécaniquement avec ledit au moins un conducteur (20) de la structure conductrice coplanaire agencée librement dans l'espace et avec effet ressort par rapport au diélectrique qui la maintient.

6. Pointe de mesure selon l'une au moins des revendications 3 à 5, **caractérisée en ce que** le conducteur de la structure conductrice coplanaire avec lequel l'élément de blindage (34) est relié électriquement et respectivement mécaniquement, est un conducteur de masse (20).

7. Pointe de mesure selon l'une au moins des revendications précédentes, **caractérisée en ce que** la structure conductrice coplanaire comprend trois conducteurs (18, 20) dans lesquels un conducteur médian (18) est un conducteur de signaux et les deux autres conducteurs (20) sont des conducteurs de masse.

8. Pointe de mesure selon l'une au moins des revendications précédentes, **caractérisée en ce qu'**un élément de blindage additionnel est agencé sur un côté opposé au côté (32) de la pointe de mesure, et réalisé de telle façon que l'élément de blindage additionnel s'étend jusque dans la région (26) de la structure conductrice coplanaire (18, 20) agencée librement dans l'espace et avec effet ressort par rapport au diélectrique (24) qui la maintient, entre le diélectrique (24) et l'extrémité côté contact (16).
